# EUROPEAN PATENT APPLICATION

(11) **EP 3 043 350 A2**
(43) Date of publication of application: **13.07.2016**
(21) Application number: 15199840.8
(22) Date of filing: 14.12.2015
(51) Int. Cl.: G11C 5/00, G11C 7/24, G11C 29/24, G11C 29/52

(54) **MEMORY DEVICE WITH DATA VALIDITY CHECK**

(30) Priority: 08.01.2015 US 201514592433
(71) Applicant: Delphi Technologies, Inc., Troy, MI 48007 (US)
(72) Inventor: BORING, Jeffrey, Todd, Kokomo, Indiana 46901 (US)
(74) Representative: Delphi France SAS

(57) **Abstract**

A memory device (10) for storing data includes a memory cell (14) and a test cell (16). The memory cell (14) is configured to indicate a data value based on a threshold voltage of the memory cell (14). The test cell (16) is configured to indicate a validity rating of the data value stored in the memory cell (14). The validity rating is determined after exposure to an environmental condition such as high temperatures and/or X-ray radiation. The validity rating is based on a test shift (22) from an initial threshold voltage of the test cell (16) prior to exposure to the environmental condition to a shifted threshold voltage of the test cell (16) after exposure to the environmental condition. The validity rating is characterized as invalid when the test shift (22) is greater than a threshold value.

## Description

### TECHNICAL FIELD OF INVENTION

This disclosure generally relates to a phase change type memory device that indicates a data value based on a threshold voltage, and more particularly relates to detecting if data stored in the device is valid after exposure to elevated temperatures or exposure to high-frequency electromagnetic radiation such as X-ray.

### BACKGROUND OF INVENTION

Threshold voltage based integrated circuit memory devices such as NAND and NOR type memory devices, which are sometimes referred to as phase change memory, are known. In such memory devices the value of the threshold voltage of a memory cell is indicative of a data value stored in the memory cells. It is also known that the value of the threshold voltage can be established and later read with enough accuracy that multiple bits of information can be stored in a single memory cell, e.g. 00, 10, 10, or 11 in a single memory cell. In some circuit board assembly manufacturing situations it is advantageous to pre-program data into the memory cells prior to soldering the memory device to a printed circuit board assembly rather than programming the memory device after solder reflow. However, exposing the memory device to temperatures sufficiently elevated to reflow the solder used to attach the memory device can cause the threshold voltage of the memory cells to shift. Once the device has been reflowed, X-ray imaging may be used to verify the part has been properly soldered, which can also contribute to threshold voltage shift. If the shift of the threshold voltage is great enough, there may be doubt as to what was the original value data stored in the memory cell, i.e. there may be doubt that the stored data is still valid. One way to determine if stored data is valid after solder reflow is to read the entire contents of the memory device and check for errors. However, this can be undesirably time consuming. For example, it may take as much as ten minutes to verify a ten-Gigabit (10Gb) memory device.

### SUMMARY OF THE INVENTION

In accordance with one embodiment, a memory device for storing data is provided. The device includes a memory cell and a test cell. The memory cell is configured to indicate a data value based on a threshold voltage of the memory cell. The test cell is configured to indicate a validity rating of the data value stored in the memory cell. The validity rating is determined after exposure to an environmental condition. The validity rating is based on a test shift from an initial threshold voltage of the test cell prior to exposure to the environmental condition to a shifted threshold voltage of the test cell after exposure to the environmental condition. The validity rating is characterized as invalid when the test shift is greater than a threshold value.

Further features and advantages will appear more clearly on a reading of the following detailed description of the preferred embodiment, which is given by way of non-limiting example only and with reference to the accompanying drawings.

### BRIEF DESCRIPTION OF DRAWINGS

The present invention will now be described, by way of example with reference to the accompanying drawings, in which:
Fig. 1 is a diagram of a memory device for access by an end user in accordance with one embodiment; and
Fig. 2 is a diagram of a portion of a memory array in the memory device of Fig. 1 in accordance with one embodiment.

### DETAILED DESCRIPTION

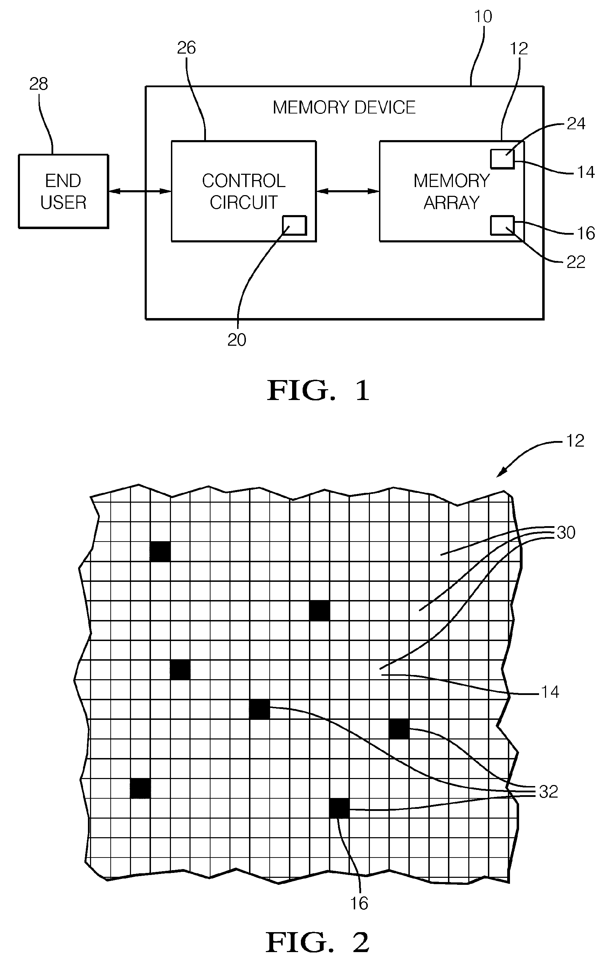

Fig. 1 illustrates a non-limiting example of a memory device for storing data, hereafter the device 10. The device 10 includes a memory array 12 configured to store, in a memory cell 14, a data value such as 0 or 1 if the memory cell 14 is being used for one-bit storage, or 00, 01, 10, 11 if the memory cell 14 is being used for two-bit storage, or other values if the memory cell 14 is being used for more-than-two-bit storage. While it is contemplated that the memory array 12 may include thousands or millions of memory cells, the memory cell 14 is referred to in the singular only so simplify the description and not to limit the number of memory cells in the memory array 12. The memory cell 14 is also configured to indicate the data value stored in the memory cell 14 based on a threshold voltage of the memory cell 14. Further information regarding the configuration and operation of memory similar to the memory array 12 is widely available; see United States Patent Number 8,077,515 to Shen et al. issued December 13, 2011, and United States Patent Number 8,116,160 to Hwang issued February 14, 2012.

If the device 10 is programmed with data prior to soldering the device 10 to, for example, a printed circuit board (not shown) as part of a printed circuit board assembly (not shown), the threshold voltage of the memory cell 14 may shift as a result of the elevated temperatures used for soldering. It is also recognized that long term exposure to elevated temperatures (e.g. 55°C) for long periods of time (e.g. 1000 hours) may also cause a threshold voltage shift. If the shift is great enough, the data value indicated by the threshold voltage of the memory cell 14 may shift enough so that a data value other than the original data value is indicated. For example, if the data value '10' was originally stored in the memory cell 14, exposure to excessive temperature or elevated temperature for an excessive amount of time may cause the threshold voltage to shift such that the subsequent threshold voltage of the memory cell 14 indicates '01' when the subsequent threshold voltage is read.

In order to facilitate detecting or predicting that the content (i.e. the threshold voltage) of the memory cell 14 may not be valid, i.e. indicating that the threshold voltage of the memory cell 14 may have shifted too much, the device 10, or more specifically the memory array 12, also includes a test cell 16 configured to indicate a validity rating 20 of the data value stored in the memory cell 14. The test cell 16 may be programmed (i.e. operated) to have a predetermined threshold voltage prior to exposure to an environmental condition. As used herein, the environmental condition may be exposure to a temperature profile used to reflow solder for attaching the device 10 to a circuit board, or the environmental condition may be a longer time of exposure to a less elevated temperature such as that experienced in an engine compartment of a vehicle or as part of an electrical assembly that dissipates relatively large amounts of power. As noted before with regard to the memory cell 14, it is contemplated the memory array 12 will have many test cells. That the test cell 16 is referred to in the singular should not be interpreted as a limitation on the device 10, but rather only for the purpose of simplifying the explanation of the device 10.

After exposure to the environmental condition, or periodically throughout the operating life of the device, the validity rating 20 may be determined based on a test shift 22 from an initial threshold voltage of the test cell 16 prior to exposure to the environmental condition to a shifted threshold voltage of the test cell 16 after exposure to the environmental condition. Accordingly, the validity rating 20 may be characterized as invalid when the test shift 22 is greater than a threshold value, forty-millivolts (40mV) for example. If the validity rating 20 is set to 'invalid' because the test shift 22 is greater than the threshold value, then it is expected that the memory cell 14 exhibits a memory shift 24 that is large enough to cause the data value indicate by the current threshold voltage of the memory cell 14 to not correspond with the data value originally stored in the memory cell 14.

The device 10 may include a control circuit 26 configured to provide an interface between the memory array 12 and an end user 28, e.g. other electronic on a circuit board assembly or test equipment. In general, the test cell 16 is not used to store a data value chosen by the end user 28, but rather is programmed or operated to exhibit a threshold voltage that is useful for the control circuit 26 to detect exposure to certain environmental conditions (e.g. temperature too high for too much time). As such, the memory cell 14 may be characterized as being accessible by the end user 28 of the device 10, and the test cell 16 may be characterized as being inaccessible by the end user 28 of the device 10. Having the test cell 16 be inaccessible, but configuring the control circuit 26 to read the threshold voltage of the test cell 16 is advantageous as it removes the computational burden from the end user 28, and allows for a much faster determination of the validity of data stored in the memory cell 14 when compared to reading the entire contents of the memory array 12 and comparing the entire contents to some outside (i.e. not in the device 10) reference list of what was stored in the device 10.

Fig. 2 further illustrates non-limiting details of the memory array 12. As mentioned above, it is contemplated that the memory cell 14 is part of (i.e. one of) a plurality of memory cells 30 arrayed across the device 10, more specifically the memory array 12. Similarly, the test cell 16 is part of (i.e. one of) a plurality of test cells 32 that are advantageously interleaved with the plurality of memory cells 30. As used herein, 'interleaved' means that the test cells 32 are scattered about amounts the memory cells 30. As such, a hypothetical memory device with operation and capability similar to the device 10 described herein, but with test cells arranged on the integrated circuit die of this hypothetical memory device at a location relatively segregated from the memory cells of this hypothetical memory device would not be comparable to this embodiment, i.e. the interleaved embodiment. It is advantageous to interleave the test cells 32 amongst the memory cells 30 so that localized hot spots on the area of die where the memory array 12 resides can be more readily detected.

An objective of the device 10 described herein is to provide a quick and easy way to determine the validity of data stored in the memory cells 30. To this end, the number or count of the memory cells 30 preferably greatly out-numbers the number or count of the test cells 32. By way of example and not limitation, a ratio of a first number of memory cells 30 in the device over a second number of test cells 32 in the device is greater than 10,000.

If the device 10 includes a plurality of the test cells 32, the validity rating (e.g. valid or invalid) may be determined based on a comparison of the test shift of each of the plurality of test cells 32. For example, the comparison may be based on an average value of the test shift of each of the plurality of test cells 32, and or a standard deviation of each of the plurality of test cells 32. By calculating a mean and standard deviation of the test shift values, the probability that a certain percentage of the memory cells 30 have shifted enough to cause the data contents to be in error can be determined using statistical analysis known to those in the statistical analysis arts. Accordingly, the device may be configured to indicate invalid data based on the comparison instead of being based on the test shift 22 of a single instance of the test cell 16. Validity may also be determined based on the amount of threshold voltage shift exhibited by the test cell with the most threshold voltage shift.

In one embodiment, the memory cell 14 has a first configuration and the test cell 16 has a second configuration different from the first configuration. As used herein, the first configuration and the second configuration refer to, for example, the particular construction used to fabricate the memory cell 14 and the test cell 16. For some memory devices it may be advantageous to have the first and second configurations match. That is the memory cell 14 and the test cell 16 have exactly the same configuration, so they exhibit similar threshold voltage shifts after being exposed to the same environmental condition. Alternatively, the second configuration may be selected such that the test shift 22 of the test cell 16 is greater (magnitude wise) than the memory shift 24 of the memory cell 14 after exposure to the environmental condition. This may be advantageous as the test cell 16 would be more sensitive to the environmental condition, and thereby give an early warning of potential problems with the validity of data indicated by the memory cell 14. Such an early warning is analogous to a canary in a coal mine.

United States Published Applications 2008/0261365 by Sasago et al., 2008/0003743 by Lee, and 2007/0257305 by Sasago et al. give examples of ways to construct phase change memory cells that are less prone to threshold voltage shift following exposure to elevated temperatures. If the memory cells 30 are constructed using the improved configuration, and the test cells 32 are constructed without the improved configuration, then the test cells 32 would be, as desired, more susceptible to threshold voltage shift than the memory cells 30.

Alternatively, the voltages applied to the test cells 32 may be different from the voltages applied to the memory cells. United States Published Applications 2013/0159796 by Bedeschi describes how bias voltages can be adjusted to reduce the tendency of the memory cells 30 to exhibit threshold voltage shifts after exposure to environmental conditions. It follows that the bias voltages applied to the test cells 32 could be different from those applied to the memory cells 30 in such a way so the test shift 22 of the test cell 16 is greater than a memory shift 24 of the memory cell 14 after exposure to the environmental condition. Accordingly, the definitions of the first configuration and the second configuration are not limited to difference in construction of the respective cells, but include differences in applied voltages when operating the respective cells. This same applied voltage can also be varied to determine the amount of shift on a memory cell.

Accordingly, a memory device (the device 10) capable of detecting when stored data may be invalid is provided. Instead of reading the content of the memory cells 30 and comparing that content to a reference list, the content of the test cells 32 can be quickly read and compared to the expected values for those test cells. The reading and comparing to expected values can be carried out by the control circuit 26 instead of being performed by the end user 28. The programming of the test cells 32 can be optimized so the indication of the stored data being valid or invalid can be more readily and reliably projected. The invalidity or validity of the stored data may be checked after specific events such as solder reflow, or may be part of an on-going memory state-of-health indicator.

While this invention has been described in terms of the preferred embodiments thereof, it is not intended to be so limited, but rather only to the extent set forth in the claims that follow.

## Claims

1. A memory device (10) for storing data, said device (10) comprising:
a memory cell (14) configured to indicate a data value based on a threshold voltage of the memory cell (14);
a test cell (16) configured to indicate a validity rating of the data value stored in the memory cell (14) after exposure to an environmental condition based on a test shift (22) from an initial threshold voltage of the test cell (16) prior to exposure to the environmental condition to a shifted threshold voltage of the test cell (16) after exposure to the environmental condition, wherein the validity rating is characterized as invalid when the test shift (22) is greater than a threshold value.

2. The device (10) in accordance with claim 1, wherein the memory cell (14) is accessible by an end user (28) of the device (10), and the test cell (16) is inaccessible by the end user (28) of the device (10).

3. The device (10) in accordance with claim 1 or 2, wherein the memory cell (14) is part of a plurality of memory cells (30) arrayed across the device (10), the test cell (16) is part of a plurality of test cells (32) interleaved with the plurality of memory cells (30).

4. The device (10) in accordance with any one of the preceding claims, wherein a ratio of a first number of memory cells (30) in the device (10) over a second number of test cells (32) in the device (10) is greater than 10,000.

5. The device (10) in accordance with any one of the preceding claims, wherein the validity rating is determined based on a comparison of the test shift (22) of each of the plurality of test cells (32).

6. The device (10) in accordance with claim 5, wherein the device (10) is configured to indicate invalid data based on the comparison.

7. The device (10) in accordance with any one of the preceding claims, wherein the memory cell (14) has a first configuration and the test cell (16) has a second configuration different from the first configuration, wherein the second configuration is such that the test shift (22) of the test cell (16) is greater than a memory shift (24) of the memory cell (14) after exposure to the environmental condition.
